# EUROPEAN PATENT APPLICATION

(11) **EP 4 579 724 A1**
(43) Date of publication of application: **02.07.2025**
(21) Application number: 23857388.5
(22) Date of filing: 23.08.2023
(51) Int. Cl.: H01L 21/683, H01L 21/66

(54) **WAFER INSPECTION DEVICE AND WAFER TRANSPORT DEVICE**

(30) Priority: 25.08.2022 JP 2022134550
(71) Applicant: NanoSystem Solutions, Inc., Uruma-shi, Okinawa 904-2311 (JP)
(72) Inventor: KONNO Junji, Uruma-shi, Okinawa 904-2311 (JP); IWATA Masahiro, Uruma-shi, Okinawa 904-2311 (JP)
(74) Representative: Strehl & Partner mbB
(86) International application number: PCT/JP2023/030364
(87) International publication number: WO 2024/043280

(57) **Abstract**

To provide a wafer inspection device and a wafer transport device capable of detecting a defect in a wafer more accurately than by conventional techniques. A wafer inspection device 11 horizontally floats the wafer 10 above an air hole block 18 by exhausting air from the air hole block 18 in which the wafer 10 is disposed toward a surface of the wafer 10. The transport unit 14 moves the wafer 10 in one direction by moving abutment units 25 to 28 with respect to the air hole block 18 by a drive unit 30, and allows the wafer 10 to pass through an inspection information acquisition unit 15 while horizontally floating the wafer 10. Accordingly, the wafer inspection device 11 acquires a light reception result as inspection information on the wafer 10 by the inspection information acquisition unit 15 when the wafer 10 passes through the inspection information acquisition unit 15, and detects a defect in the wafer 10 based on the light reception result by the detection unit 16.

## Description

### Technical Field

The present invention relates to a wafer inspection device and a wafer transport device.

### Background Art

In the related art, as defects in a wafer, microcracks generated during manufacturing or transportation, pinhole defects introduced during crystal growth, twin defects, slip defects introduced during wafer heat treatment, scratches introduced during wafer transportation, and the like are known. These defects include a defect reaching from a back surface to a front surface of the wafer (defect penetrating to the front surface), a defect present only on the front surface or the back surface of the wafer (defect not penetrating to the front surface), and a defect present inside the wafer and invisible from the front surface and the back surface of the wafer.

As a wafer inspection device for inspecting a defect existing inside a wafer, there is known a wafer inspection device capable of detecting a defect or the like existing between a front surface and a back surface of the wafer by perpendicularly irradiating an inspection surface of the wafer with infrared rays or X-rays (hereinafter, also simply referred to as irradiation light) and detecting an intensity of transmitted light of the infrared rays or the X-rays transmitted through the inspection surface (for example, see Patent Literature 1).

### Citation List

### Patent Literature

Patent Literature 1: JP2020-26954A

### Summary of Invention

### Technical Problem

However, in the wafer inspection device described above, since a center of the wafer is horizontally held at the time of inspection, warpage or deflection may occur on an outer peripheral side of the wafer due to its own weight, and it may be difficult for the irradiation light from a light source to perpendicularly enter the inspection surface of the wafer due to unintended warpage or deflection occurring in the wafer. As described above, when the irradiation light is not perpendicularly incident on the inspection surface of the wafer, there is a problem that it is difficult to accurately detect a defect inside the wafer. In addition, even in a wafer inspection device that inspects a scratch or the like on a surface of a wafer by imaging the surface of the wafer with an imaging unit such as a camera, when warpage or deflection occurs on the outer peripheral side of the wafer, there are problems that it is difficult to image the inspection surface of the wafer by the imaging unit, and it is difficult to accurately detect a defect outside the wafer.

An object of the present invention is to provide a wafer inspection device and a wafer transport device capable of detecting a defect in a wafer more accurately than by conventional techniques.

### Solution to Problem

A wafer inspection device according to the present invention is a wafer inspection device for inspecting presence or absence of a defect in a wafer, the wafer inspection device including: a stage on which the wafer is to be disposed on an air hole block and horizontally floated above the air hole block by exhausting air from the air hole block toward a surface of the wafer; a transport unit configured to transport the wafer horizontally floated above the stage by the air in one direction with respect to the stage; an inspection information acquisition unit for acquiring inspection information on the wafer; and a detection unit for detecting presence or absence of a defect in the wafer based on the inspection information on the wafer acquired by the inspection information acquisition unit, in which the transport unit includes an abutment unit that abuts against an outer peripheral edge of the wafer horizontally floated above the stage by the air, and a drive unit that moves the abutment unit with respect to the stage, and moves the wafer in the one direction by moving the abutment unit with respect to the stage by the drive unit, and allow the wafer to pass through the inspection information acquisition unit while horizontally floating the wafer, and the inspection information acquisition unit acquires the inspection information on the wafer when the wafer passes through.

Further, a wafer transport device according to the present invention is a wafer transport device that allows a wafer to pass through an inspection information acquisition unit for acquiring inspection information acquired from the wafer to inspect presence or absence of a defect in the wafer based on the inspection information, the wafer transport device including: a stage on which the wafer is to be disposed on an air hole block and horizontally floated above the air hole block by exhausting air from the air hole block toward a surface of the wafer; and a transport unit configured to transport the wafer horizontally floated above the stage by the air in one direction with respect to the stage, in which the transport unit includes an abutment unit that abuts against an outer peripheral edge of the wafer horizontally floated above the stage by the air, and a drive unit that moves the abutment unit with respect to the stage, and moves the wafer in the one direction by moving the abutment unit with respect to the stage by the drive unit, and allow the wafer to pass through the inspection information acquisition unit while horizontally floating the wafer.

### Advantageous Effects of Invention

According to the present invention, since it is possible to prevent occurrence of warpage or deflection of a wafer by horizontally floating the wafer by air, an influence of the warpage or deflection of the wafer is reduced at the time of inspection for a defect, and accordingly, the defect in the wafer can be detected more accurately than by conventional techniques.

### Brief Description of Drawings

Fig. 1 is a perspective view illustrating an overall configuration of a wafer inspection device according to the present embodiment.
Fig. 2 is a schematic view illustrating a state in which a wafer is disposed at an initial position in the wafer inspection device illustrated in Fig. 1.
Fig. 3 is a schematic view illustrating a state in which the wafer is moved to a return position in the wafer inspection device illustrated in Fig. 1.
Fig. 4 is a perspective view illustrating a configuration of an inspection information acquisition unit.
Fig. 5 is an explanatory view for explaining a position where a light receiving unit receives transmitted light through the wafer.
Fig. 6 is a schematic view illustrating a state (1) in which a wafer is transported on an air hole block.
Fig. 7 is a schematic view illustrating a state (2) in which the wafer is transported on the air hole block.
Fig. 8 is an explanatory view for explaining a twin defect appearing at a predetermined position with respect to a notch.
Fig. 9 is an explanatory diagram for explaining a twin defect appearing at other positions different from Fig. 8.
Fig. 10 is an explanatory view for explaining a transport unit of another embodiment for transporting a wafer in one direction.
Fig. 11 is an explanatory view for explaining a transport unit of another embodiment for transporting a wafer in the other direction.
Fig. 12 is an explanatory view illustrating an example in which the wafer passes through the inspection information acquisition unit by being brought into contact with only an abutment unit upstream of a moving direction, and is brought into contact with an abutment unit downstream of the moving direction before the wafer stops at an initial position and a return position.

### Description of Embodiments

A wafer inspection device according to an embodiment of the present invention will be described below with reference to the drawings. In the following description, the same components are denoted by the same reference numerals, and redundant description will be omitted.

### (1) Outline of wafer inspection device

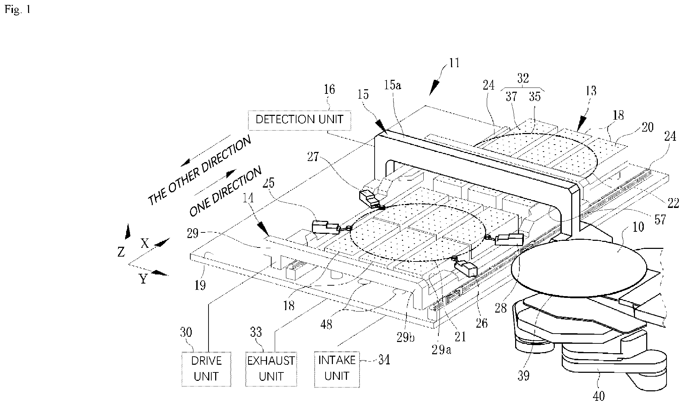

Fig. 1 illustrates an overall configuration of a wafer inspection device 11. Here, as a wafer 10 to be inspected by the wafer inspection device 11, a patternless wafer that has been enlarged in diameter and thinned for manufacturing a large number of semiconductors will be described below as an example. In the present embodiment, the wafer inspection device 11 for detecting a defect that exists inside the wafer 10 and is invisible from a front surface and a back surface of the wafer 10, such as a twin defect, will be described below as an example. Here, for convenience of description, a surface disposed on the wafer 10 is referred to as a front surface, and a surface disposed below the wafer 10 is referred to as a back surface.

As illustrated in Fig. 1, the wafer inspection device 11 includes a stage 13, a transport unit 14, an inspection information acquisition unit 15, and a detection unit 16. In the present embodiment, a configuration including the stage 13 and the transport unit 14, excluding the inspection information acquisition unit 15 and the detection unit 16, is referred to as a wafer transport device.

The stage 13 includes a plurality of air hole blocks 18, a base 19 on which the air hole blocks 18 are disposed, an exhaust unit 33 that supplies air to the air hole blocks 18 and exhausts the air from the air hole blocks 18, and an intake unit 34 that suctions the air via the air hole blocks 18. In the stage 13, the plurality of air hole blocks 18 are regularly arranged on the base 19 and fixed to the base 19. The plurality of air hole blocks 18 have the same configuration, and are formed of, for example, a porous member having a plurality of air hole holes 32, such as porous carbon, and have a configuration that allows air to pass through. As illustrated in Fig. 1, each of the air hole blocks 18 according to the present embodiment has a rectangular shape in which a length in an X direction which is a transport direction of the wafer 10 in the wafer inspection device 11 is larger than a length in a Y direction which is a width direction of the wafer inspection device 11. The plurality of air hole blocks 18 are arranged in a matrix in the Y direction and the X direction at predetermined intervals. A Z direction illustrated in Fig. 1 is a height direction orthogonal to the X direction and the Y direction.

In addition, the exhaust unit 33 including an exhaust pump, a compressed cylinder, or the like, and the intake unit 34 including a vacuum pump or the like are connected to the air hole blocks 18. The air hole block 18 has a configuration in which air supplied from the exhaust unit 33 can be exhausted to the outside from an upper transport surface 20 on which the wafer 10 is disposed. Further, the air hole block 18 has a configuration capable of suctioning external air from the transport surface 20 by suctioning air from the intake unit 34. Accordingly, the air hole block 18 exhausts air from the transport surface 20 toward the back surface of the wafer 10, and suctions air between the transport surface 20 and the back surface of the wafer 10 to adjust a pressure between the transport surface 20 and the back surface of the wafer 10, thereby horizontally floating the wafer 10 above the transport surface 20.

In this case, the air hole block 18 has a configuration in which a plurality of exhaust holes 35 for exhausting air toward the back surface of the wafer 10 and a plurality of intake holes 37 for suctioning air between the back surface of the wafer 10 and the plurality of exhaust holes 35 are formed in the transport surface 20 as the air hole holes 32, the exhaust unit 33 is connected to each exhaust hole 35, and the intake unit 34 is connected to each intake hole 37. The number of the intake holes 37 is smaller than the number of the exhaust holes 35, and the intake holes 37 are provided at positions different from the exhaust holes 35 on the transport surface 20.

The exhaust holes 35 provided in the air hole block 18 exhaust air from the transport surface 20 to the back surface of the wafer 10 to increase the pressure between the wafer 10 and the transport surface 20, thereby floating the wafer 10 from the transport surface 20. On the other hand, the intake holes 37 suction air from the transport surface 20, thereby reducing the pressure between the wafer 10 and the transport surface 20 to generate a negative pressure, and suctioning the wafer 10 toward the transport surface 20. Accordingly, the exhaust holes 35 and the intake holes 37 are controlled by the exhaust unit 33 and the intake unit 34 to regulate exhaust and intake, and the wafer 10 is stably and continuously horizontally floated above the transport surface 20.

The transport unit 14 is configured to transport (hereinafter, also referred to as "horizontal transport") the wafer 10 horizontally floated by the air hole block 18 while maintaining the horizontally floated state between an initial position 21 and a return position 22. In the wafer inspection device 11, the initial position 21 and the return position 22 are determined in advance on the stage 13, and in the following description, a linear direction from the initial position 21 toward the return position 22 is referred to as one direction, and a linear direction from the return position 22 toward the initial position 21, which is a direction opposite to the one direction, is referred to as the other direction. In Fig. 1, the one direction and the other direction are directions along the X direction.

The transport unit 14 includes a pair of guide rails 24 provided on the stage 13, a transport frame portion 29 movable along the guide rails 24, a plurality of abutment units 25, 26, 27, and 28 provided on the transport frame portion 29, and a drive unit 30 that moves the transport frame portion 29 along the guide rails 24. The pair of guide rails 24 extend in parallel in the X direction on both sides of a region where the plurality of air hole blocks 18 are disposed on the stage 13, and have a configuration in which the transport frame portion 29 is slidably provided.

The transport frame portion 29 includes a frame-shaped frame portion 29b having a hollow opening 29a in a central region, and is formed such that the air hole block 18 is exposed in the opening 29a. The frame portion 29b is formed to a size that allows the wafer 10 to be disposed in the hollow region of the opening 29a, and the frame portion 29b is formed such that the wafer 10 can be horizontally floated in the hollow region of the opening 29a by adjusting the air by the air hole block 18.

In addition, in the frame portion 29b, the plurality of abutment units 25 to 28 capable of abutting against an outer peripheral edge of the wafer 10 horizontally floated over the air hole block 18 by air are provided around the opening 29a. In addition, the drive unit 30 is connected to the frame portion 29b according to the present embodiment, and a driving force is applied from the drive unit 30. Accordingly, the frame portion 29b slides in the X direction along the guide rails 24 based on the driving force from the drive unit 30.

The abutment units 25 to 28 include first abutment units 25 and 26 capable of abutting against one outer peripheral edge of the wafer 10, and second abutment units 27 and 28 disposed to face the first abutment units 25 and 26 across the wafer 10 in the X direction and capable of abutting against the other outer peripheral edge of the wafer 10. Here, when not specifically distinguished, the first abutment units 25 and 26 and the second abutment units 27 and 28 are simply referred to as abutment units 25 to 28. In the present embodiment, a side on which the first abutment units 25 and 26 are disposed is referred to as a rear side of the wafer 10, and a side on which the second abutment units 27 and 28 are disposed is referred to as a front side of the wafer 10. In this example, in the outer peripheral edge of the wafer 10, a portion closer to the initial position 21 than a diameter parallel to the Y direction passing through a center of the wafer 10 is one outer peripheral edge, and a portion closer to the return position 22 than the diameter is the other outer peripheral edge.

In this case, when the wafer 10 is loaded onto the air hole block 18 exposed in the opening 29a of the frame portion 29b at the initial position 21 by a loader/unloader 40 to be described later in a state in which the air is exhausted and suctioned by the air hole block 18 and the wafer 10 can be horizontally floated, the abutment units 25 to 28 moves so as to abut against the outer peripheral edge of the horizontally floated wafer 10 by rising from a back surface side of the wafer 10 or approaching the outer peripheral edge of the wafer 10 from a radial direction of the wafer 10. In addition, when the horizontally floated wafer 10 after the inspection by the inspection information acquisition unit 15 to be described later is unloaded by the loader/unloader 40 at the initial position 21, the abutment units 25 to 28 move to a non-contact state with the wafer 10 by descending from the back surface side of the wafer 10 or moving away from the wafer 10 in the radial direction of the wafer 10, so as not to hinder the unloading of the horizontally floated wafer 10.

Since the abutment units 25 to 28 are fixed to the transport frame portion 29, the abutment units 25 to 28 move along the X direction together with the transport frame portion 29 when the transport frame portion 29 moves in the X direction along the guide rails 24. The abutment units 25 to 28 abut against the outer peripheral edge of the wafer 10 horizontally floated over the air hole block 18. When the transport frame portion 29 moves in one direction as it is, the wafer 10 is pushed in one direction while being horizontally floated, and the wafer 10 is moved from the initial position 21 to the return position 22. Accordingly, the wafer 10 passes through the inspection information acquisition unit 15 on a transport path from the initial position 21 to the return position 22.

When the wafer 10 is moved to the return position 22, the transport frame portion 29 moves in the other direction while keeping the abutment units 25 to 28 in contact with the outer peripheral edge of the horizontally floated wafer 10. Accordingly, the abutment units 25 to 28 push the wafer 10 in the other direction while being horizontally floated, and move the wafer 10 from the return position 22 to the initial position 21. The initial position 21 is a position where the wafer 10 is loaded or unloaded. The return position 22 is a completion position where the wafer 10 is moved in one direction and finishes passing through the inspection information acquisition unit 15.

The first abutment units 25 and 26 according to the present embodiment are disposed symmetrically with respect to a central axis that is one direction (X direction passing through the center) passing through the center of the wafer 10 in a plan view so that a force applied to one outer peripheral edge of the wafer 10 becomes uniform when the first abutment units 25 and 26 abut against one outer peripheral edge of the wafer 10 at the initial position 21 and allow the wafer 10 to move in one direction. Similarly, the second abutment units 27 and 28 are also disposed symmetrically with respect to a central axis that is the other direction (X direction passing through the center) passing through the center of the wafer 10 in a plan view so that the force applied to the other outer peripheral edge of the wafer 10 becomes uniform when the second abutment units 27 and 28 abut against the other outer peripheral edge of the wafer 10 at the return position 22 and allow the wafer 10 to move in the other direction. The number of the abutment units 25 to 28 is not limited to four and may be five or more as long as the wafer 10 can be pushed with the same force.

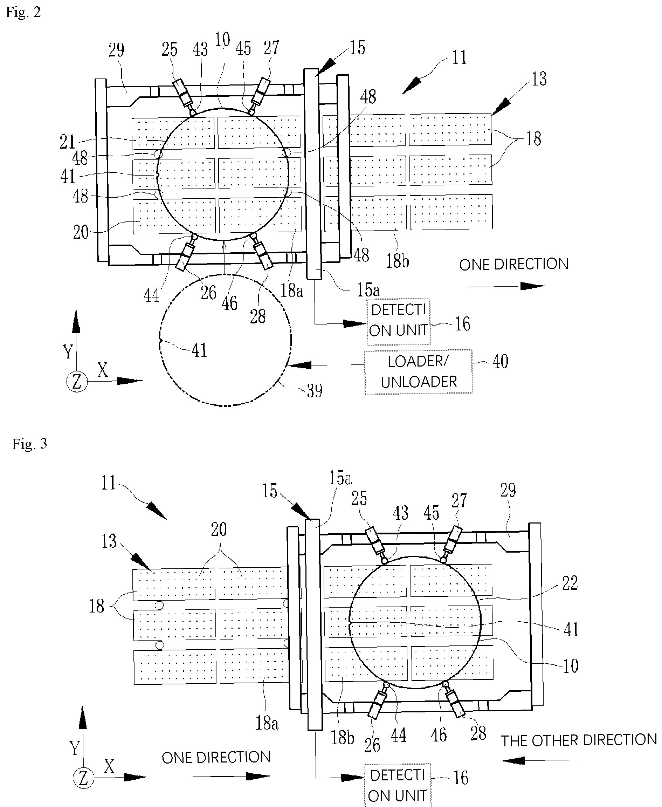

Fig. 2 illustrates the initial position 21 of the wafer 10. In the present embodiment, the inspection information acquisition unit 15 to be described later is disposed between air hole blocks (indicated by reference numerals 18a and 18b in Fig. 2) that are adjacent to each other in the X direction and provided between the initial position 21 and the return position 22. In the following description, when the air hole blocks 18 adjacent to each other in the X direction are particularly distinguished from each other, the air hole blocks 18 are denoted by reference numerals 18a and 18b. As illustrated in Fig. 2, a load/unload position 39 is provided outside the stage 13. At the load/unload position 39, the loader/unloader 40 for loading and unloading the wafer 10 is provided. The loader/unloader 40 sets (loads) the wafer 10 one by one from the load/unload position 39 to the initial position 21. The wafer 10 is set at the initial position 21 such that a notch 41 provided at a predetermined position of the outer peripheral edge of the wafer 10 is disposed at a predetermined position.

The wafer 10 moved from the initial position 21 to the return position 22 and subjected to the inspection is returned from the return position 22 to the initial position 21 again. When the wafer 10 returns from the return position 22 to the initial position 21 again, the loader/unloader 40 unloads the wafer 10, which has been inspected again, from the initial position 21. Loading and unloading directions of the loader/unloader 40 are, for example, the Y direction orthogonal to the one direction.

The abutment units 25 to 28 according to the present embodiment are provided, at tips thereof, with holders 43, 44, 45, and 46 each having, for example, a U-shaped cross section and an open portion. In the present embodiment, for example, each of the holders 43 to 46 is movable between a contact position where the holder is in contact with the outer peripheral edge of the wafer 10 located at the initial position 21 and a retracted position where the holder is radially away from the contact position toward the outside of the outer peripheral edge of the wafer 10.

When the wafer 10 is set at the initial position 21, the holders 43 to 46 move from the retracted position to the contact position. At the contact position, the outer peripheral edge of the wafer 10 slightly enters the open portions of the holders 43 to 46, but a contact region with the outer peripheral edge of the wafer 10 is reduced as much as possible. When the transport frame portion 29 moves in one direction or the other direction, the holders 43 to 46 are simply brought into contact with the outer peripheral edge of the horizontally floated wafer 10, and by pushing the wafer 10 as it is, the horizontally floated wafer 10 is transported while being horizontally floated. As described above, when the wafer 10 is transported, the holders 43 and 44 (first abutment units 25 and 26) or the holders 45 and 46 (second abutment units 27 and 28) on the side (upstream side) on which the wafer 10 is pushed in the transport direction (one direction or the other direction) may contact the outer peripheral edge of the wafer 10 and push the wafer 10 in the transport direction. Therefore, the holders 43 to 46 may not only be configured to allow the outer peripheral edge of the wafer 10 to enter, but may also simply be configured to contact the outer peripheral edge of the wafer 10.

The base 19 is formed with four holes 48 each accommodating a rod-shaped arm (not illustrated) that can protrude along a height direction Z between the air hole blocks 18. When the arm is in a non-protruding state from the hole 48, the tip of the arm is located at a position (retracted position) lower than the transport surface 20 of the air hole block 18. When the arm is in a protruding state from the hole 48, the tip of the arm is located at a position (lifting position) higher than the transport surface 20, and the arm raises and lowers the wafer 10 at the initial position 21 as necessary.

In this case, first, after the wafer 10 is disposed at the initial position 21 by the loader/unloader 40, the arm protrudes from the hole 48 to a position higher than the transport surface 20 via a space between the air hole blocks 18, thereby raising the wafer 10. Accordingly, the arm receives the wafer 10 from the loader/unloader 40. During this time, air is exhausted and suctioned from the air hole block 18, and a pressure for horizontally floating the wafer 10 is applied. Thereafter, after the loader/unloader 40 moves from the load/unload position 39, the arm is lowered and retracted into the hole 48, whereby the wafer 10 supported by the arm is maintained in a state of being horizontally floated over the transport surface 20 by air at the initial position 21. Thereafter, the holders 43 to 46 of the abutment units 25 to 28 move to the contact position and abut against the outer peripheral edge of the wafer 10. When the transport frame portion 29 is moved from the initial position 21 to the return position 22, that is, moved in one direction by the drive unit 30, the wafer 10 in contact with the abutment units 25 to 28 of the transport frame portion 29 is also moved from the initial position 21 to the return position 22.

Fig. 3 illustrates the return position 22 of the wafer 10. The inspection information acquisition unit 15 is disposed between the initial position 21 and the return position 22 of the wafer 10. Accordingly, when the wafer 10 moves in one direction from the initial position 21 toward the return position 22, the wafer 10 passes through an opening 57 of an opening formation unit 15a of the inspection information acquisition unit 15. When the wafer 10 passes through the opening 57 of the opening formation unit 15a, the inspection information acquisition unit 15 irradiates the front surface of the wafer 10 with irradiation light linearly extending in the Y direction, receives transmitted light from the back surface, and outputs an obtained light reception result (light information) to the detection unit 16. Accordingly, the detection unit 16 inspects the presence or absence of a defect in the wafer 10 based on the light reception result received as inspection information. When a twin defect is inspected as a defect, a change in birefringence due to a photoelastic effect caused by the twin defect is detected from a change in phase of transmitted light by using, for example, a crossed Nicols method.

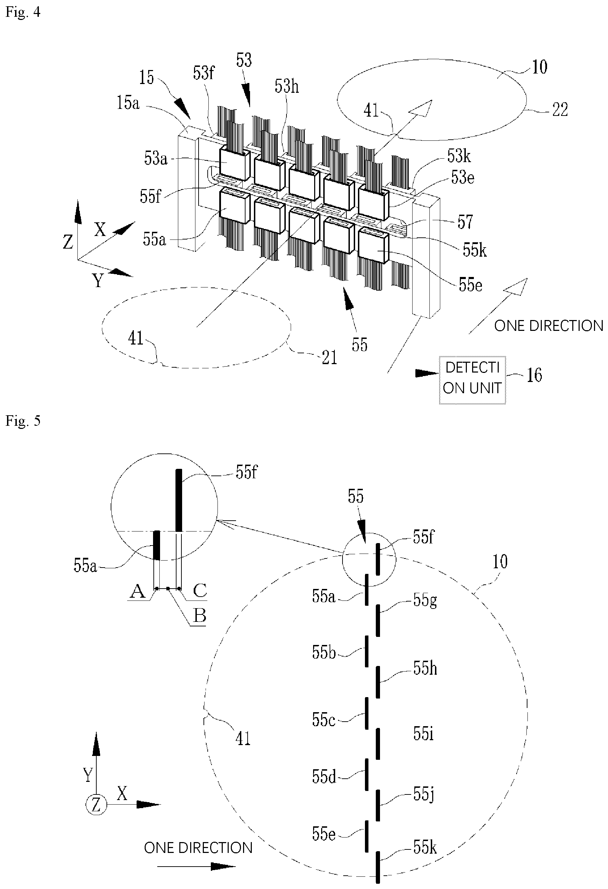

Next, a configuration of the inspection information acquisition unit 15 will be described. As illustrated in Fig. 4, the inspection information acquisition unit 15 includes the opening formation unit 15a, a light source group 53, and a light receiving unit group 55. The opening formation unit 15a is formed in a frame shape and is fixed to the base 19. The opening formation unit 15a is formed with the opening 57 configured to allow the horizontally floated wafer 10 and the transport frame portion 29 to pass therethrough, the wafer 10 being moved in one direction and the other direction by the transport unit 14, and the transport frame portion 29 being moved in one direction and the other direction together with the wafer 10. In the opening formation unit 15a, the light source group 53 and the light receiving unit group 55 are disposed to face each other in the Z direction with the opening 57 interposed therebetween.

In the present embodiment, the light source group 53 is disposed above the opening 57 of the opening formation unit 15a, and the light receiving unit group 55 capable of receiving irradiation light from the light source group 53 is provided below the opening 57. The light source group 53 includes a plurality of light sources 53a to 53k, and the light receiving unit group 55 includes the same number of light receiving units 55a to 55k as the light sources 53a to 53k. The light source group 53 irradiates the front surface of the wafer 10 with irradiation light from each of the light sources 53a to 53k when the horizontally floated wafer 10 passes through the opening 57. At this time, the wafer 10 is horizontally floated by the air, and the wafer 10 is free from warping or bending, and is maintained substantially horizontally from the center to the outer peripheral edge. Therefore, the light source group 53 can emit the irradiation light from the direction (height direction Z) of the surface normal perpendicular to the front surface of the wafer 10.

The light receiving unit group 55 receives, by each of the light receiving units 55a to 55k, transmitted light obtained by transmitting the irradiation light perpendicularly to the surface of the wafer 10, and outputs a light reception result obtained for each of the light receiving units 55a to 55k to the detection unit 16. Here, Fig. 5 illustrates a reading range of the light receiving unit group 55, and specific arrangement positions of the light sources 53a to 53k and the light receiving units 55a to 55k will be described below with reference to Fig. 5. Since the light sources 53a to 53k and the light receiving units 55a to 55k are disposed to face each other in the Z direction, the following description will be made focusing on the positions of the light receiving units 55a to 55k.

As illustrated in Fig. 5, the light receiving units 55a to 55k are disposed to face the corresponding light sources 53a to 53k in the Z direction, respectively, and are arranged in two rows in a staggered manner along the Y direction orthogonal to the one direction (X direction) in which the wafer 10 moves. Specifically, the first row of light receiving units 55a to 55e arranged in a row at predetermined intervals along the Y direction and the second row of light receiving units 55f to 55k arranged in a row at predetermined intervals along the Y direction are arranged in rows shifted by a distance B in the X direction. In Fig. 5, a reference sign A denotes a light receiving width of transmitted light in the first row of light receiving units 55a to 55e, and a reference sign C denotes a light receiving width of transmitted light in the second row of light receiving units 55f to 55k.

The first row of light receiving units 55a to 55e are arranged to fill unirradiated regions of the irradiation light formed between the adjacent light receiving units 55f to 55k in the second row. The light receiving unit group 55 can receive the transmitted light in an entire region of the wafer 10 in the Y direction by the first row of light receiving units 55a to 55e and the second row of light receiving units 55f to 55k. As described above, the light receiving units 55a to 55e can receive the transmitted light of the entire surface of the wafer 10 by continuously receiving the transmitted light transmitted through the wafer 10 from an outer peripheral end on the front side to an outer peripheral end on the rear side of the wafer 10 as the wafer 10 passes through the opening 57.

In the present embodiment, as illustrated in Fig. 5, a region in which the transmitted light is received by the first row of light receiving units 55a to 55e and a region in which the transmitted light is received by the second row of light receiving units 55f to 55k are arranged so as not to partially overlap each other in the X direction and so as to be able to continuously receive the transmitted light in the Y direction, but the present invention is not limited thereto. For example, the region in which the transmitted light is received by the first row of light receiving units 55a to 55e and the region in which the transmitted light is received by the second row of light receiving units 55f to 55k may be arranged so as to partially overlap each other in the X direction. In this case, the detection unit 16 may delete data on any one of the region in which the transmitted light is received by the first row of light receiving units 55a to 55e and the region in which the transmitted light is received by the second row of light receiving units 55f to 55k, and obtain a light reception result similar to the light reception result obtained by continuously receiving the transmitted light in the Y direction.

The detection unit 16 detects a defect inside the wafer 10 based on an intensity of the transmitted light obtained from the light receiving units 55a to 55k. At this time, since the detection unit 16 detects the presence or absence of a defect in the wafer 10 based on the transmitted light transmitted perpendicularly to the surface of the wafer 10, various defects such as a twin defect inside the wafer 10 can be more accurately detected without being affected by warpage, deflection, or the like occurring in the wafer 10.

In the present embodiment, after the inspection is performed on the wafer 10 passing through the inspection information acquisition unit 15 when the wafer 10 moves in one direction from the initial position 21 toward the return position 22, the inspection is also performed on the wafer 10 passing through the inspection information acquisition unit 15 when the wafer 10 moves again in the other direction from the return position 22 toward the initial position 21. The inspection information acquisition unit 15 may inspect the presence or absence of a defect in the wafer 10 only when the wafer 10 moves in one direction from the initial position 21 toward the return position 22, or may inspect the presence or absence of a defect in the wafer only when the wafer 10 moves in the other direction from the return position 22 toward the initial position 21.

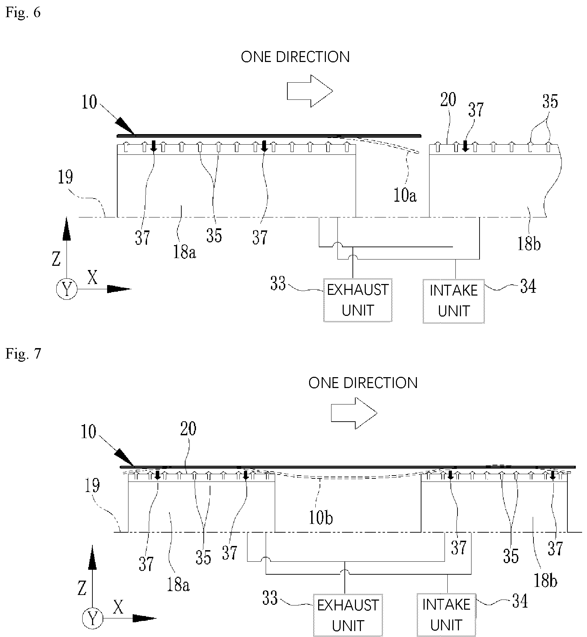

Here, the inspection information acquisition unit 15 is disposed between the air hole blocks 18a and 18b adjacent to each other in the X direction. Therefore, in a place where the inspection information acquisition unit 15 is disposed, it is necessary to form a space between the air hole blocks 18a and 18b in which the light source group 53 and the light receiving unit group 55 can be disposed. Therefore, as illustrated in Fig. 6, in the exhaust unit 33 and the intake unit 34, the exhaust and suction of air are adjusted such that the pressure is also uniform between the air hole blocks 18a and 18b, so that the wafer 10 passes between the air hole blocks 18a and 18b while being horizontally floated without being deformed due to its own weight in a gap between the air hole blocks 18a and 18b in which the inspection information acquisition unit 15 (not illustrated in Fig. 6) is disposed.

In the air hole blocks 18a and 18b, exhaust and suction amounts of air are adjusted, or the formation positions, the number, and the sizes of the exhaust holes 35 and the intake holes 37 are adjusted, a positive pressure is applied to a space between the air hole blocks 18a and 18b and the wafer 10 by exhaust of air from the exhaust holes 35, and a negative pressure is applied to a space between the air hole blocks 18a and 18b and the wafer 10 by suction of air from the intake holes 37. Accordingly, the wafer 10 is maintained in a uniformly and horizontally floated state without an uneven load by the transport surfaces 20 of the air hole blocks 18a and 18b and a fluid film formed along an upper portion between the air hole blocks 18a and 18b by adjusting the positive pressure and the negative pressure.

The movement of the wafer 10 between the air hole blocks 18a and 18b becomes smooth by an effect of a preload applied by the negative pressure. That is, when the negative pressure is not applied, an outer peripheral edge of a wafer 10a may be bent as indicated by a dotted line in Fig. 6. Therefore, by drawing the wafer 10 toward the transport surface 20 by the suction of the intake holes 37, the rigidity of the fluid film is enhanced, and the deflection of the wafer 10 that occurs when the wafer 10 moves between the air hole blocks 18a and 18b can be prevented.

As illustrated in Fig. 7, even when the wafer 10 having a small thickness and being easily deformed due to its own weight is passed between the air hole blocks 18a and 18b having a large interval, the effect of the preload makes it possible to precisely maintain a planar state of the wafer 10 and to horizontally float the wafer 10. By applying the negative pressure by the preload, displacement or vibration in the Z direction (height direction) with respect to the wafer 10 is less likely to occur, and for example, as indicated by a dotted line in Fig. 7, a wafer 10b in a wavy state can be prevented.

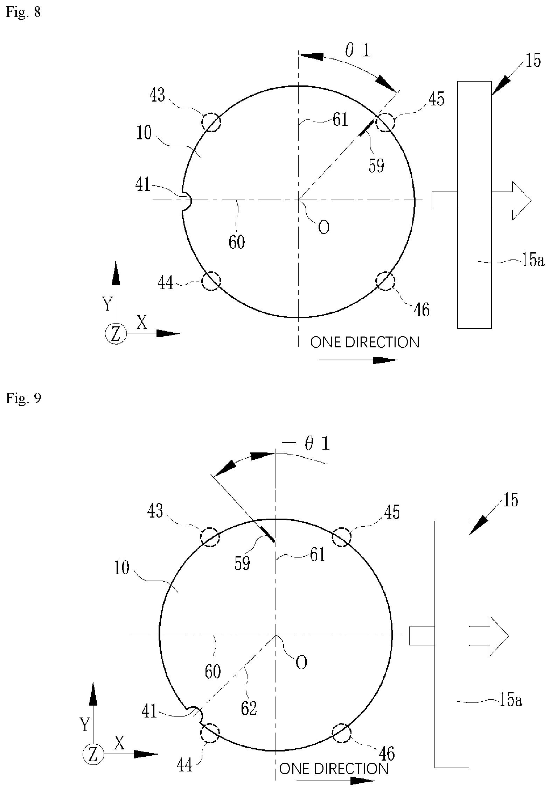

Next, a method of arranging the wafer 10 for facilitating detection of a twin defect formed in the wafer 10 by the wafer inspection device 11 will be described below. Fig. 8 illustrates an example of the wafer 10 in which a twin defect 59 is likely to be formed at a position at a predetermined angle with respect to the notch 41. In the wafer 10, the twin defect 59 extending radially from a center O of the wafer 10 toward the outer peripheral edge is formed around the outer peripheral edge located at a predetermined angle with respect to the notch 41. In this way, for the wafer 10 in which a location where the twin defect 59 is likely to occur can be predicted with reference to the notch 41, when the presence or absence of the twin defect 59 of the wafer 10 is inspected using the wafer inspection device 11 according to the present embodiment, it is desirable to determine an arrangement direction of the wafer 10 at the initial position 21 with reference to a position of the notch 41 so that the twin defect 59 is easily detected by the inspection information acquisition unit 15.

That is, in this example, it is desirable that the wafer 10 is disposed at the initial position 21 of the stage 13 such that a reference line 60 passing through a formation position of the notch 41 and the center O of the wafer 10 coincides with one direction (X direction) which is a moving direction of the wafer 10. When the wafer 10 is disposed at the initial position 21 in such a direction with reference to the position of the notch 41, the wafer 10 horizontally floated by the holders 43 to 46 is pushed in one direction as it is and passes through the inspection information acquisition unit 15 without rotation.

In this case, in a plan view, the wafer 10 is arranged such that the twin defect 59 is positioned at an angle θ1 (for example, 45 degrees) with respect to an orthogonal line 61 that extends in the Y direction orthogonal to one direction (X direction) which is a moving direction when the wafer 10 passes through the inspection information acquisition unit 15 and passes through the center O of the wafer 10. Accordingly, in the wafer inspection device 11, the twin defect 59 has an angle close to the angle θ1 with respect to an irradiation line (Y direction) of the irradiation light emitted by the inspection information acquisition unit 15, and the twin defect 59 is easily detected based on the light reception result.

Fig. 9 illustrates an example in which the twin defect 59 is formed at another position of the wafer 10. Fig. 9 illustrates an example of the wafer 10 in which the twin defect 59 extending from a predetermined position of the wafer 10 toward the outer peripheral edge is likely to be formed around the outer peripheral edge located at a predetermined angle with respect to the notch 41. In a plan view, the wafer 10 in which such a twin defect 59 is likely to occur is arranged such that the twin defect 59 is positioned at an angle (angle between the orthogonal line 61 and an extension direction of the twin defect 59) -θ1 (for example, -45 degrees) with respect to the orthogonal line 61 that extends in the Y direction orthogonal to one direction (X direction) which is a moving direction when the wafer 10 passes through the inspection information acquisition unit 15 and passes through the center O of the wafer 10. Accordingly, in the wafer inspection device 11, the twin defect 59 has an angle close to the angle -θ1 with respect to the irradiation line (Y direction) of the irradiation light emitted by the inspection information acquisition unit 15, and the twin defect 59 is easily detected based on the light reception result.

### (2) Operation and Effect

In the above configuration, the wafer inspection device 11 horizontally floats the wafer 10 above the air hole block 18 by exhausting air from the air hole block 18 in which the wafer 10 is disposed toward the surface of the wafer 10. The transport unit 14 moves the wafer 10 in one direction by moving the abutment units 25 to 28 with respect to the air hole block 18 by the drive unit 30, and allows the wafer 10 to pass through the inspection information acquisition unit 15 while horizontally floating the wafer 10. Accordingly, the wafer inspection device 11 can acquire a light reception result as inspection information on the wafer 10 by the inspection information acquisition unit 15 when the wafer 10 passes through the inspection information acquisition unit 15, and detect a defect in the wafer 10 based on the light reception result by the detection unit 16.

In this way, in the wafer inspection device 11, it is possible to prevent occurrence of warpage or deflection of the wafer 10 by horizontally floating the wafer 10 by air. Therefore, an influence of the warpage or deflection of the wafer 10 is reduced during the inspection of the presence or absence of a defect in the wafer 10, and accordingly, the defect in the wafer can be detected more accurately than by conventional techniques.

The transport unit 14 allows the first abutment units 25 and 26 to abut against one outer peripheral edge of the wafer 10 and moves the first abutment units 25 and 26 with respect to the stage 13 by the drive unit 30, thereby moving the wafer 10 in one direction while horizontally floating the wafer 10 and allowing the wafer 10 to pass through the inspection information acquisition unit 15 (first transport operation). After passing through the inspection information acquisition unit 15 by the first transport operation, the transport unit 14 allows the second abutment units 27 and 28 to abut against the other outer peripheral edge of the wafer 10 and moves the second abutment units 27 and 28 with respect to the stage 13 by the drive unit 30, thereby moving the wafer 10 in the other direction opposite to the one direction while horizontally floating the wafer 10 and allowing the wafer 10 to pass through the inspection information acquisition unit 15 again (second transport operation). In this way, by executing the first transport operation and the second transport operation, the wafer inspection device 11 can inspect the presence or absence of a defect in the wafer 10 each time when the wafer 10 passes through the inspection information acquisition unit 15 twice, and can accurately detect the defect in the wafer 10 accordingly.

In the wafer inspection device 11, the transmitted light through the wafer 10 can be received by simply allowing the wafer 10 to pass between the plurality of light sources 53a to 53k and the plurality of light receiving units 55a to 55k linearly arranged along the direction orthogonal to the one direction in which the wafer 10 moves, and the defect in the wafer 10 can be detected based on the obtained light reception result. Accordingly, the wafer inspection device 11 of the present embodiment can improve throughput at the time of defect inspection of the wafer 10, for example, as compared with a wafer inspection device in the related art in which a pair of a light source and a light receiving unit are moved in a radial direction with respect to a rotating wafer, and at this time, transmitted light through the wafer is received to detect a defect in the wafer.

### (3) Other Embodiments

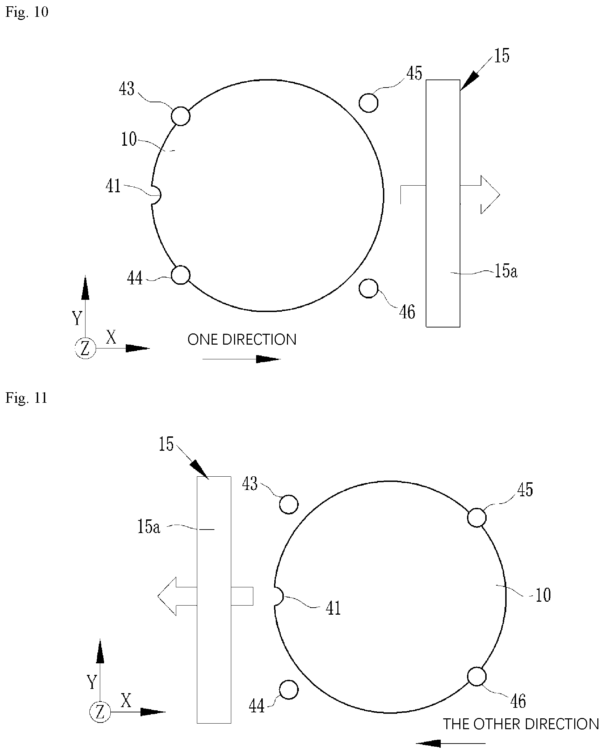

In the above embodiment, the case where the four holders 43 to 46 all abut against the outer peripheral edge of the wafer 10 and the wafer 10 is moved by the four holders 43 to 46 when the horizontally floated wafer 10 is moved in one direction and the other direction has been described, but the present invention is not limited thereto. For example, as illustrated in Fig. 10, when the wafer 10 is moved in one direction, only the holders 43 and 44 located on the rear side of the wafer 10 among the holders 43 to 46 may abut against the wafer 10, the remaining holders 45 and 46 located on the front side of the wafer 10 may do not abut against the wafer 10, and the wafer 10 may be pushed and moved in one direction only by the holders 43 and 44.

In this case, since the holders 45 and 46 do not abut against the wafer 10 when the wafer 10 passes through the inspection information acquisition unit 15, the holders 45 and 46 allow the outer peripheral edge of the wafer 10 to be exposed and not hidden. Accordingly, in the inspection information acquisition unit 15, it is possible to irradiate a portion of the wafer 10 that does not abut against the holders 45 and 46 with the irradiation light, and to reduce an uninspected region.

As illustrated in Fig. 11, when the wafer 10 is moved in the other direction, only the holders 45 and 46 located on the front side of the wafer 10 among the holders 43 to 46 may abut against the wafer 10, the remaining holders 43 and 44 located on the rear side of the wafer 10 may do not abut against the wafer 10, and the wafer 10 may be pushed and moved in the other direction only by the holders 45 and 46. Accordingly, similarly to the above, in the inspection information acquisition unit 15, it is possible to irradiate a portion of the wafer 10 that does not abut against the holders 43 and 44 with the irradiation light, and to reduce an uninspected region. In this way, by changing the holders 43 to 46 abutting against the wafer 10 according to the moving direction of the wafer 10, the data on the entire surface of the wafer 10 can be acquired by two inspections performed when the wafer 10 moves from the initial position 21 to the return position 22 and from the return position 22 to the initial position 21.

Here, when the wafer 10 is clamped by the holders 43 and 44 and the holders 45 and 46 as described above, stress may be generated in the wafer 10 by the holders 43 to 46. In a case where the wafer inspection device 11 detects a crystal defect such as a twin defect based on a change in birefringence due to a photoelastic effect of the wafer 10, when the stress as described above is generated in the wafer 10, it may be difficult to detect the crystal defect in a portion where the stress is generated. However, in this embodiment, while the wafer 10 passes through the inspection information acquisition unit 15 (irradiation line of the irradiation light) as described above, only an abutment unit upstream of the wafer 10 in the transport direction (upstream in the moving direction) abuts against the wafer 10, and the wafer 10 is pushed and moved by the abutment unit. That is, when the wafer 10 is moved in one direction, only the holders 43 and 44 of the first abutment units abut against the wafer 10, and when the wafer 10 is moved in the other direction, only the holders 45 and 46 of the second abutment units abut against the wafer 10, thereby pushing and moving the wafer 10. Accordingly, it is possible to prevent stress from being generated in the wafer 10 due to the wafer 10 being clamped by the holders 43 and 44 and the holders 45 and 46. Thus, it is possible to prevent the influence of the stress of the wafer 10 when the twin defect in the wafer 10 is detected.

Also in this embodiment, the configuration in which the holders 43 to 46 enter the outer peripheral edge of the wafer 10 is not essential, and as described above, the configuration may be adopted in which the holders 43 and 44 (first abutment units 25 and 26) or the holders 45 and 46 (second abutment units 27 and 28) simply come into contact with the outer peripheral edge of the wafer 10 and push the wafer 10 in the moving direction without entering the outer peripheral edge of the wafer 10. Further, the entire surface of the wafer 10 can be inspected twice by the reciprocating movement of the wafer 10 between the initial position 21 and the return position 22, and the data on the entire surface of the wafer 10 can be acquired in each of the two inspections.

As described above, when the wafer 10 is moved by bringing only the abutment unit on the upstream side in the transport direction into contact with the wafer 10 while the wafer 10 passes through the inspection information acquisition unit 15, it is preferable to bring the abutment unit downstream of the wafer 10 in the transport direction (downstream in the moving direction) into contact with the wafer 10 before the movement of the wafer 10 is stopped.

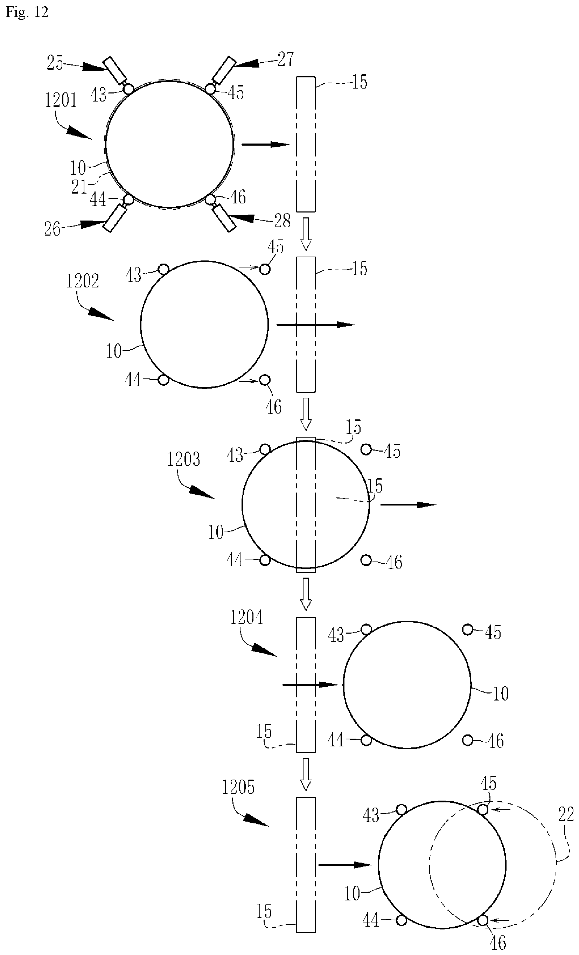

Fig. 12 illustrates an example in which the abutment unit downstream of the wafer 10 in the transport direction is brought into contact with the wafer 10 before the wafer 10 is stopped as described above. In this example, when the wafer 10 is loaded at the initial position 21, the holders 43 to 46 of the abutment units 25 to 28 move to the contact position and abut against the outer peripheral edge of the wafer 10 (step 1201). By the movement of the transport frame portion 29 in one direction, the wafer 10 starts to be transported from the initial position 21 toward the return position 22 while the holders 43 to 46 are in contact with the wafer 10. That is, both the first abutment units 25 and 26 and the second abutment units 27 and 28 are brought into contact with the wafer 10 to stop the wafer 10 at the initial position 21. The movement is started from this stop state, and both the first abutment units 25 and 26 and the second abutment units 27 and 28 are also brought into contact with the wafer 10 at the start of the movement.

During the movement of the wafer 10, before the wafer 10 reaches the inspection information acquisition unit 15 (that is, before the outer peripheral edge on the front side of the wafer 10 reaches the irradiation line of the irradiation light), the holders 45 and 46 of the second abutment units 27 and 28 downstream of the wafer 10 in the transport direction are placed at the retracted position and do not abut against the wafer 10 (in a non-contact state) (step 1202). The timing when the holders 45 and 46 are placed at the retracted position may be, for example, immediately before the outer peripheral edge on the front side of the wafer 10 reaches the irradiation line, immediately after the wafer 10 starts to move toward the return position, or an intermediate position therebetween.

Accordingly, the wafer 10 passes through the inspection information acquisition unit 15 (irradiation line of the irradiation light) while the holders 45 and 46 are placed at the retracted position (steps 1203 and 1204) . That is, the wafer 10 passes through the inspection information acquisition unit 15 while only the holders 43 and 44 of the first abutment units 25 and 26 upstream of the wafer 10 in the transport direction come into contact with the outer peripheral edge and the wafer 10 is pushed by the holders 43 and 44.

After the wafer 10 passes through the inspection information acquisition unit 15 and before the wafer 10 reaches the return position 22 (that is, before the wafer 10 stops moving in one direction), the holders 45 and 46 of the second abutment units 27 and 28 abut against the wafer 10 at the contact position (in a contact state) (step 1205). The wafer 10 is transported to the return position 22 while both the holders 43 and 44 of the first abutment units 25 and 26 and the holders 45 and 46 of the second abutment units 27 and 28 are in contact with the wafer 10, and the transport is stopped at that time.

Thereafter, when the wafer 10 is transported in the other direction (that is, from the return position 22 toward the initial position), the movement of the wafer 10 is started while the holders 43 to 46 of the abutment units 25 to 28 are at the contact position. During the movement in the other direction, before the wafer 10 reaches the inspection information acquisition unit 15, the holders 43 and 44 of the first abutment units 25 and 26 are placed at the retracted position and do not abut against the wafer 10 (in a non-contact state). Accordingly, the wafer 10 passes through the inspection information acquisition unit 15 while only the holders 45 and 46 of the second abutment units 27 and 28 are brought into contact with the outer peripheral edge and the wafer 10 is pushed by the holders 45 and 46. After the wafer 10 passes through the inspection information acquisition unit 15 and before the wafer 10 reaches the initial position 21 (that is, before the wafer 10 stops moving in the other direction), the holders 43 and 44 of the first abutment units 25 and 26 abut against the wafer 10 at the contact position (in a contact state). The wafer 10 is stopped at the initial position 21 while both the holders 43 and 44 of the first abutment units 25 and 26 and the holders 45 and 46 of the second abutment units 27 and 28 are in contact with the wafer 10.

As described above, before the wafer 10 stops moving at the return position 22 or the initial position 21, the first abutment units 25 and 26 and the second abutment units 27 and 28 disposed to face each other across the wafer 10 are brought into contact with the wafer 10. Accordingly, in a state in which a posture of the wafer 10 is stabilized, that is, the wafer 10 is brought into contact with the abutment units 25 to 28 without moving in the Y direction or rotating about an axis in the Z direction, the movement of the wafer 10 is stopped.

In this example, the return position 22 is set as a position where the wafer 10 reaches after passing through the inspection information acquisition unit 15 when the wafer 10 is moved in one direction. Similarly, the initial position 21 is set as a position where the wafer 10 reaches after passing through the inspection information acquisition unit 15 when the wafer 10 is moved in the other direction. In this example, the abutment units 25 to 28 are configured to simply come into contact with the outer peripheral edge of the wafer 10 without covering the front surface and the back surface of the wafer 10. For example, the cylindrical holders 43 to 46 are provided at the tips of the abutment units 25 to 28. These cylindrical holders 43 to 46 are provided with axial directions oriented in the thickness direction (Z direction) of the wafer 10, and peripheral surfaces thereof are in point contact with the outer peripheral edge of the wafer 10.

Further, in each of the above embodiments, the wafer inspection device 11 for detecting a defect in the patternless wafer (unpatterned wafer) 10 has been described, but the present invention is not limited thereto, and may be applied to, for example, a wafer detection device for detecting a defect in a wafer at various stages such as a patterned wafer.

In each of the above embodiments, the wafer inspection device 11 for inspecting the presence or absence of a twin defect inside the wafer 10 has been described, but the present invention is not limited thereto, and may be applied to, for example, a wafer inspection device for inspecting presence or absence of defects such as scratches and unevenness on the surface of the wafer, which are external defects, crystal defects present only on the surface of the wafer, and defects present only inside the wafer and invisible from the front surface and the back surface of the wafer. In this case, the inspection information acquisition unit is changed depending on the type of the defect to be inspected, and the inspection information acquisition unit capable of acquiring inspection information for detecting the presence or absence of a desired defect is used.

Further, in each of the above embodiments, the case where the inspection information acquisition unit 15 that acquires the light reception result of the transmitted light obtained by irradiating the wafer 10 with the irradiation light is applied as an inspection information acquisition unit for acquiring the inspection information on the wafer has been described, but the present invention is not limited thereto. As another inspection information acquisition unit, for example, an inspection information acquisition unit that acquires a light reception result of reflected light reflected by the surface of the wafer by irradiating the wafer 10 with the irradiation light, or an inspection information acquisition unit that acquires a captured image as inspection information by imaging the surface of the wafer 10 with an imaging unit such as a camera may be applied.

In the above embodiments, the exhaust holes 35 and the intake holes 37 included in the air hole block 18 may be formed by mechanical processing. Further, if the wafer 10 can be horizontally floated only by the exhaust of air from the air hole block 18, an air hole block in which only the exhaust holes 35 are formed may be applied.

### Reference Sign List

- 10: wafer
- 11: wafer inspection device
- 13: stage
- 14: transport unit
- 15: inspection information acquisition unit
- 16: detection unit
- 18: air hole block
- 25~28: abutment unit
- 53a~53k: light source
- 55a~55k: light receiving unit

## Claims

1. A wafer inspection device for inspecting presence or absence of a defect in a wafer, the wafer inspection device comprising:
a stage on which the wafer is to be disposed on an air hole block and horizontally floated above the air hole block by exhausting air from the air hole block toward a surface of the wafer;
a transport unit configured to transport the wafer horizontally floated above the stage by the air in one direction with respect to the stage;
an inspection information acquisition unit for acquiring inspection information on the wafer; and
a detection unit for detecting a defect in the wafer based on the inspection information on the wafer acquired by the inspection information acquisition unit, wherein
the transport unit includes
an abutment unit that abuts against an outer peripheral edge of the wafer horizontally floated above the stage by the air, and
a drive unit that moves the abutment unit with respect to the stage, and
moves the wafer in the one direction by moving the abutment unit with respect to the stage by the drive unit, and allow the wafer to pass through the inspection information acquisition unit while horizontally floating the wafer, and
the inspection information acquisition unit acquires the inspection information on the wafer when the wafer passes through.

2. The wafer inspection device according to claim 1, wherein
the air hole block is formed of a porous member and includes an exhaust hole for exhausting air toward the surface of the wafer and an intake hole for suctioning air between the air hole block and the surface of the wafer, and by exhaust of the air from the exhaust hole and suction of the air from the intake hole, a pressure between the air hole block and the surface of the wafer is adjusted, and the wafer is horizontally floated above the air hole block.

3. The wafer inspection device according to claim 1, wherein
the inspection information acquisition unit includes
a plurality of light sources disposed along a direction orthogonal to the one direction in which the wafer moves, and
a plurality of light receiving units disposed to face the light sources along the direction orthogonal to the one direction in which the wafer moves, and
when the wafer passes between the light sources and the light receiving units, the light receiving units receive transmitted light through the wafer by irradiating the wafer with irradiation light from the light sources, and output an obtained light reception result to the detection unit as the inspection information.

4. The wafer inspection device according to claim 3, wherein
the stage is provided with a plurality of the air hole blocks,
the inspection information acquisition unit includes an opening formation unit provided between the adjacent air hole blocks and having an opening to allow the wafer moving in the one direction to pass therethrough, and
the plurality of light sources and the plurality of light receiving units are disposed to face each other across the opening in the opening formation unit.

5. The wafer inspection device according to claim 1, wherein
the abutment unit includes
a plurality of first abutment units that abut against one outer peripheral edge of the wafer, and
a plurality of second abutment units that are disposed to face the plurality of first abutment units across the wafer and abut against the other outer peripheral edge of the wafer, and
the transport unit executes
a first transport operation of allowing the plurality of first abutment units to abut against the one outer peripheral edge of the wafer and moving the plurality of first abutment units with respect to the stage by the drive unit, thereby moving the wafer in the one direction while horizontally floating the wafer and allowing the wafer to pass through the inspection information acquisition unit, and
a second transport operation of, after passing the wafer through the inspection information acquisition unit by the first transport operation, allowing the plurality of second abutment units to abut against the other outer peripheral edge of the wafer and moving the plurality of second abutment units with respect to the stage by the drive unit, thereby moving the wafer in the other direction opposite to the one direction while horizontally floating the wafer and allowing the wafer to pass through the inspection information acquisition unit again.

6. The wafer inspection device according to claim 5, wherein
in the first transport operation, the plurality of second abutment units do not abut against the wafer at least while the wafer passes through the inspection information acquisition unit, and
in the second transport operation, the plurality of first abutment units do not abut against the wafer at least while the wafer passes through the inspection information acquisition unit.

7. The wafer inspection device according to claim 6, wherein
in the first transport operation, the plurality of second abutment units abut against the wafer during a period from when the wafer passes through the inspection information acquisition unit to when the movement in the one direction stops, and
in the second transport operation, the plurality of first abutment units abut against the wafer during a period from when the wafer passes through the inspection information acquisition unit to when the movement in the other direction stops.

8. The wafer inspection device according to claim 1, wherein
the abutment unit includes
a plurality of first abutment units that abut against one outer peripheral edge of the wafer, and
a plurality of second abutment units that are disposed to face the plurality of first abutment units across the wafer and abut against the other outer peripheral edge of the wafer,
the transport unit executes
a transport operation of allowing the plurality of first abutment units to abut against the one outer peripheral edge of the wafer and moving the plurality of first abutment units with respect to the stage by the drive unit, thereby moving the wafer in the one direction while horizontally floating the wafer and allowing the wafer to pass through the inspection information acquisition unit, and
when the movement of the wafer in the one direction by the transport operation stops, the plurality of second abutment units abut against the wafer during a period from when the wafer passes through the inspection information acquisition unit to when the movement in the one direction stops.

9. A wafer transport device that allows a wafer to pass through an inspection information acquisition unit for acquiring inspection information acquired from the wafer to inspect presence or absence of a defect in the wafer based on the inspection information, the wafer transport device comprising:
a stage on which the wafer is to be disposed on an air hole block and horizontally floated above the air hole block by exhausting air from the air hole block toward a surface of the wafer; and
a transport unit configured to transport the wafer horizontally floated above the stage by the air in one direction with respect to the stage, wherein
the transport unit includes
an abutment unit that abuts against an outer peripheral edge of the wafer horizontally floated above the stage by the air, and
a drive unit that moves the abutment unit with respect to the stage, and
moves the wafer in the one direction by moving the abutment unit with respect to the stage by the drive unit, and allow the wafer to pass through the inspection information acquisition unit while horizontally floating the wafer.
